# EUROPEAN PATENT APPLICATION

(11) **EP 3 789 776 A1**
(43) Date of publication of application: **10.03.2021**
(21) Application number: 20194134.1
(22) Date of filing: 02.09.2020
(51) Int. Cl.: G01R 22/06, H02J 7/00, H02J 7/34

(54) **SMART UTILITY METER WITH REDUCED BATTERY SELF-DISCHARGE**

(30) Priority: 03.09.2019 DK PA201970551
(71) Applicant: Kamstrup A/S, 8660 Skanderborg (DK)
(72) Inventor: Hald, Flemming, 8660 Skanderborg (DK)
(74) Representative: Plougmann Vingtoft a/s

(57) **Abstract**

A utility meter for measuring an amount of a utility delivered to a consumer and for transmitting consumption related data to a meter reading system. The utility meter includes a radio circuit powered by a power supply circuit. The utility meter is battery operated and energy is supplied from the battery to the power supply circuit. The utility meter further includes a controller unit arranged to analyse radio signals received by the radio circuit. To decouple current peaks from the battery a capacitor is charged by the battery through a current limiting circuit. The current limiting circuit is controlled by the controller unit to have a normal mode and a boost mode where the charging current is limited more in normal mode than in boost mode. The controller unit is configured to analyse a radio signal received by the radio receiver to determine a parameter of the received radio signal and to control the current limiting circuit to switch to the boost mode according to the determined parameter.

## Description

### FIELD OF THE INVENTION

The present invention relates to the field of battery operated smart utility meters with communication interfaces for remote reading.

### BACKGROUND OF THE INVENTION

Smart utility meters are generally known in the art. Utility companies uses such smart utility meters for measuring the amount of a utility delivered to a consumption site and to communicate the measured consumption data and other data related to the utility or the meter to a reading system. Especially battery operated meters are typically using radio frequency (RF) communication or other wireless communication interfaces.

Smart utility meters are typically battery-powered, and consequently have a finite amount of energy available for their service cycle. Because a service cycle for meter devices of typically 10-20 years is desirable to reduce cost associated with meter exchange or battery replacement, energy conservation is a major design criterion. Energy from the battery is used for measuring the amount of received utility, powering displays, reception and transmission of consumption data through radio interfaces and other communication interfaces and other operational tasks of the utility meter. Due to the extended lifetime of the meter leak currents in electronic components does as well contribute significantly to the total energy consumption or energy budget of the product. Especially leak currents in in the battery itself, also called self-discharge, will consume a considerable part of the energy available in the battery of the utility meter. Minimizing self-discharge of the battery is thus essential to achieve a long product lifetime without the need for a battery change.

Over time batteries, such as Lithium Thionyl Chloride batteries build up a passivation layer internally in the battery. The passivation layer reduces the self-discharge. The passivation layer is, however, destroyed by high current peaks drawn out of the battery e.g. during periods of radio transmission or reception. After a high current peak has occurred the passivation layer will start rebuilding in a subsequent period of low current consumption. To minimize this problem the battery is often coupled to a capacitor through a serial resistor, in that way the battery is decoupled and protected from high current peaks by the resistor, while peak currents still may be delivered to the rest of the meter circuit from the capacitor. However the duration of the peak currents are limited by the size of the capacitor. The serial resistor has the disadvantage that it limits the amount of energy that can be delivered from the battery over a limited time period i.e. the power that can actually be delivered by the battery.

Modern smart utility meters provide measurements for analytic purposes, which require advanced measurements of the utility and extended communication sessions for transfer of data, as well as conventional consumption measurements for billing purposes, which include highly optimized data transfer of consumption data. The first requires a high amount of energy delivered over an extended time period while the latter may be performed using short energy bursts. To account for the demand for high power for some applications the size of the capacitor may be increased so that a larger amount of energy can be buffered and delivered during periods of high demand. Capacitors are however expensive, especially Hybrid Layer Capacitors (HLC) are often used, which adds significantly to the cost of the smart utility meter compared to traditional cheaper capacitors.

Energy conservation is a major design criterion for battery operated smart utility meters. Hence, an improved and cost effective smart utility meter capable of providing advanced functionality requiring high energy while at the same time protecting the battery from high currents would be advantageous, in particular a more efficient, cost optimized and versatile decoupling of the battery would be advantageous.

### OBJECT OF THE INVENTION

It is as an object of the present invention to provide a versatile battery operated utility meter that solves the above mentioned problems of the prior art.

It is a further object of the present invention to provide an alternative to the prior art.

### SUMMARY OF THE INVENTION

Thus, the above described object and several other objects are intended to be obtained in a first aspect of the invention by providing a utility meter for measuring the amount of a utility delivered to a consumption site and for transmitting consumption related data to a meter reading system, the utility meter comprising: a radio transmitter and a radio receiver; a power supply circuit arranged to power the radio receiver; a battery arranged to supply energy to the power supply circuit; and a controller unit configured to analyse a radio signal received by the radio receiver, wherein the power supply circuit comprises: a capacitor arranged to be charged by the battery and to supply energy to the radio transmitter and / or receiver; and a current limiting circuit arranged to limit a charging current running from the battery to the power supply circuit, characterized in that, the current limiting circuit is controlled by the controller unit to have a normal mode and a boost mode where the charging current is limited more in normal mode than in boost mode and in that the controller unit is configured to analyse a radio signal received by the radio receiver to determine a parameter of the received radio signal and to control the current limiting circuit to switch to the boost mode according to the determined parameter.

Thus, an object of the invention is solved by letting the controller unit of the utility meter determine a parameter of the received radio signal, i.e. a parameter describing one or more properties or characteristics of the radio signal being received, and control the current limiting circuits of the power supply according to the determined parameter. The invention has the advantage that the characteristics of the power supply circuit is dynamically adapted according to the functions being active in the utility meter. This has the effect that the supply circuit may operate in the normal mode and switch to the boost mode only when required e.g. due to a period of high energy consumption i.e. a high average current delivered by the power supply circuit. The Normal mode has the effect that it protects the battery from severe degeneration of a passivation layer inside the battery and supports regeneration of the same passivation layer. The passivation layer reduces self-discharge of the battery. The boost mode has the effect that it still limits or reduces degeneration of the passivation while at the same time allowing for an increased power consumption compared to the normal mode. Unnecessary switches to boost mode are undesired as they will lead to severe degeneration of the passivation layer in the battery. When the controller unit analyses the received radio signal to determine a parameter which is used to control the current limiting circuit the battery is protected against undesired switches to boost mode in that a switch to boost mode only is performed if required according to the determined parameter. The boost mode has the further effect that the capacitance of the capacitor may be optimized / kept at a minimum whereby component cost is reduced.

The power supply circuit is arranged to power at least the radio receiver but may be arranged to power the radio transmitter and radio receiver or a radio transceiver. The power supply circuit may power only parts of the radio circuit. The power supply circuit may further supply other parts of the meter, including the controller unit and measurement circuits such as the sensor for measuring the delivered utility.

The controller unit is configured to analyse the radio signal received by the radio receiver, this is to be interpreted in the broadest sense. The controller unit may demodulate the received radio signal and as such become, or be understood as, a part of the radio receiver circuit. The controller unit may include a software defined radio arranged to receive a sampled radio signal.

The parameter determined by the controller unit may be any parameter linked to the received signal including physical parameters such as a received signal strength or a signal to noise relation or other kinds of distortions or characteristics of the signal including the duration / length of the radio signal.

A parameter of the received radio signal is construed to mean a parameter describing the radio signal being received. The controller unit may be configured to analyse the radio signal received by the radio receiver to determine a parameter describing one or more physical properties of the received radio signal, and to control the current limiting circuit to switch to the boost mode according to the determined parameter.

The controller unit may further be configured to determine the parameter of the received radio signal during reception / processing the radio signal and switch between normal mode and boost mode during reception and/or processing of the received radio signal. This has the advantage the current limiting circuit of the power supply is adapted to the properties / parameters of the radio signal being received / processed while it is being received / processed. Thus, a change of mode to boost mode is made if the radio signal being received require a change to boost mode due to current consumption of the receiver / controller unit.

By processing the received radio signal may be understood digital signal processing in the form of digital signal processing e.g. used in a software defined radio. Processing of the received radio signal may further include processing, parsing, integrity checking, authentication and decryption of the received radio signal in the form of a data packet. Processing of the received radio signal may also include de-spreading if spread spectrum technologies are used and error correction if forward error correction is used.

The controller unit / radio receiver may perform a measurement on the received radio signal to obtain the determined parameter such as physical parameters of the received radio signal. Alternatively the received radio signal may be demodulated and processed by the controller unit to obtain a data packet comprising data fields from which the determined parameter is derived.

The received parameter may simply be the duration of the received signal. The duration of the received signal may be measured by the radio receiver / controller unit measuring on the received radio signal or calculated based on a length field in the received data packed. The determined parameter may also be derived from data included in the radio signal received. The determined parameter may be at least partly contained in a data field included in the radio signal received. The controller unit may analyse the radio signal received to determine a parameter related to one or more length fields in headers or other parts of a received data packet/ radio signal. In example the determined parameter may be the length of the data packet / radio signal to be received. The length of the data packet / radio signal may be described in a length field of the data packet. If the length of the data packet / radio signal to be received is more than a suitable limit, i.e. the length is above a threshold, the current limiting circuit is switched to boost mode.

The controller unit may analyse the radio signal received to determine a parameter related to one or more fields in headers or other parts of a received data packet, such as a preamble or a synchronization word, describing the type of packet or type of communication session. Advanced communication sessions may include several bursts of radio signals to be received and transmitted. The several bursts may each be a data packet or may be combined to one data packet. The controller unit may analyse the radio signal received to determine a parameter related to one or more fields in headers or other parts of a received data packet describing the number of radio signal bursts to be received or transmitted. In example the determined parameter may be a number of radio signal bursts to be received or a signal describing that multiple bursts will be received. If the number of radio bursts exceeds a suitable limit or threshold the current limiting circuit is switched to boost mode. Alternatively the parameter related to the timing of radio signal bursts may be determined, especially the pauses or spaces in time between radio communication bursts where the radio circuit does not need to be active.

The capacitor may be any suitable type of capacitors such as a tantalum capacitor, electrolyte capacitor, super capacitor, Hybrid Layer Capacitor (HLC) or any other capacitor.

The current limiting circuit may be any circuit suitable for limiting the charge current running out of the battery and into the power supply circuit. The current limiting may consist of only passive components but may include active components. The current limiting circuit need not to generate a constant current but may let the current depend on battery output voltage and capacitor voltage. The charging current being limited more in normal mode than in boost mode shall be understood as the charging current being higher in boost mode than in normal mode at the same battery voltage and capacitor voltage given there is a significant difference between the battery voltage and capacitor voltage. The current limiting circuit may be understood as a part of the power supply circuit and as such limits the current running into the power supply circuit. The current limiting circuit as such is limiting the charging current running from the battery to the capacitor.

The utility meter may be arranged for measuring any utility such as water, gas, heating, cooling or electricity delivered to a consumption site. The utility meter may be a heat cost allocator or any type of submeter used for consumption allocation between more consuming entities. The consumption site may be domestic building such as a residence or apartment or industrial building, hotels, hospitals etc.

The current limiting circuit may comprise a variable resistor. Alternative one or more transistors may be configured to create a current limiting circuit. The current limiting circuit may comprise at least two resistors and at least one switch arranged to create a variable serial resistance through which the charging current is running, where the switch is controlled by the controller unit. The switch may be any electrical controllable switch such as a transistor or FET. The switch may be an output port in the controller unit. The current limiting circuit may comprise two or more resistors connected to switches or output ports of a microcontroller to create a variable resistor.

The controller unit may be configured to determine a duration of the received radio signal and control the current limiting circuit according to the determined duration of the received radio signal. If the duration of the radio signal is long the capacitor voltage may start to decrease and become insufficient to supply the radio circuit. If the controller unit detects that the duration of the radio signal is longer than what can be accommodated by normal mode it may switch the mode of the power supply to boost mode. In a system where long radio signal are occurring very rarely the power supply circuit will only be switched to boost mode when it is absolutely necessary. This has the advantage of protecting the battery from high current peaks occurring during boost mode.

The controller unit may further be configured to measure the capacitor voltage and control the current limiting circuit to switch to the boost mode according to the determined parameter of the received radio signal and the measure of the capacitor voltage.

The controller unit may be configured to analyse the received radio signal to determine a communication sequence type and control the current limiting circuit according to the determined communication sequence type. Some communication sequences include multiple reception and transmission bursts, such sequences are described in the wireless MBus standard EN13757-4:2013 and EN 13757-3:2018 and 13757-7:2018. These bursts may be spaced in time, such that the radio circuit does not need to be constant active, giving the capacitor enough time to be at least partly recharged during the spaces. The spaces in time may be too short to recharge the capacitor when the power supply circuit is in normal mode. In boost mode, however, the spaces are sufficient to at least partly charge the capacitor to reach a level of equilibrium which allows the extended communication session to continue without the capacitor voltage dropping below the minimum supply voltage for the radio circuit. The communication sequence type may be used as a parameter for switching the current limiting circuit to boost mode if the communication sequence type is a type including multiple radio signal sequences.

The controller unit may be configured to analyse the received radio signal to determine an expected duration of the received signal and control the current limiting circuit according to the determined expected duration. The length field of a data packet is often part of the packet header and may as such be received at the start of a communication session. The length field may as such be used as a parameter for switching the power supply circuit to boost mode if the length exceeds a suitable limit.

The controller unit may be configured to analyse the received radio signal to determine if the received radio signal is the start of a communication session including multiple radio signal bursts to be received and control the current limiting circuit according to the number of radio signal bursts to be received.

The controller unit may analyse the radio signal to determine more than one of the above mentioned parameters and use the determined parameters in a combination for determining if the power supply circuit should be switched to boost mode.

It is understood by the skilled person that the power supply circuit may have more than two modes and that these modes may be controlled by more than one parameter or by different or individual parameters. Especially the current limiting circuit may have several modes limiting the charging currents differently.

### BRIEF DESCRIPTION OF THE FIGURES

The utility meter according to the invention will now be described in more detail with regard to the accompanying figure. The figure show one way of implementing the present invention and is not to be construed as being limiting to other possible embodiments falling within the scope of the attached claim set.

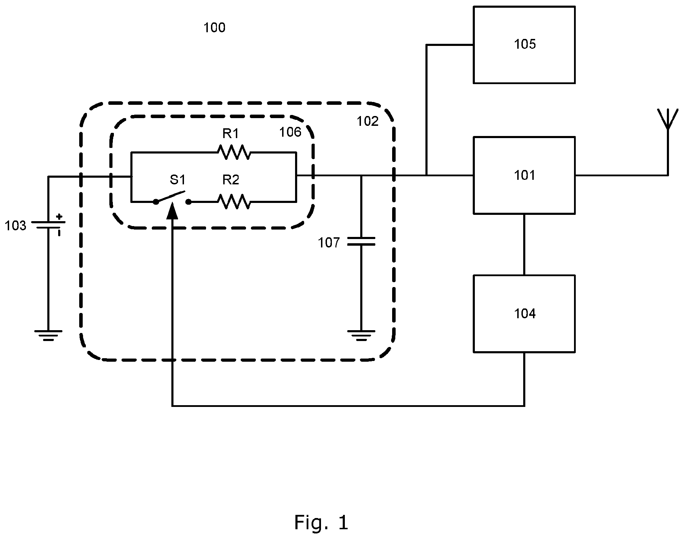

Figure 1 illustrates in a schematic way a utility meter including a power supply circuit and a battery.

### DETAILED DESCRIPTION OF AN EMBODIMENT

Figure 1 illustrates a utility meter 100, with a radio circuit 101 comprising a radio receiver and a radio transmitter, a power supply circuit 102, a battery 103, a controller unit 104 and a sensor 105 arranged to perform measurements on a delivered utility. The power supply circuit supplies at least the receiver of the radio circuit but may also supply other circuits such as the controller unit, the transmitter or the sensor.

The power supply circuit 102 is designed to protect the battery from high current peaks. Current peaks will destroy a passivation layer build up inside the battery. The passivation layer inside the battery reduces self-discharge of the battery. This means that prevention of high peak currents drawn directly from the battery will protect the passivation layer, whereby the self-discharge is minimized and battery lifetime is extended. The radio circuit may typically draw a current in the range of 5-50 mA, which will destroy the passivation layer if drawn directly from the battery. To decouple the battery from such current peaks a capacitor is included from which high current peaks can be drawn. The limited size of the capacitor does set a limit to the duration of the current peaks and thus to the time duration in which the radio circuit may be active.

To preserve the passivation layer the current peaks running from the battery shall be kept low such as below 500 µA or even below 250 µA or as low as 50 µA. However it has turned out that infrequent higher peak currents of up to 1 mA or even 5mA has only a small influence on the passivation layer. This has the effect that functionalities used infrequently may have a higher energy consumption if the power supply circuit has the flexibility to deliver such a higher power in a boost mode without allowing the higher peak currents from the battery during normal mode operation.

The circuits supplied by the power supply circuits often has varying current consumption or operates in bursts such as radio circuit transmitting or receiving a sequence of radio bursts or a sensor sampling temperature or flow with a sampling interval. Thus it is often convenient to talk about average currents. In the following description the currents will be average currents unless specifically mentioned as peak currents.

The power supply circuit is supplied from the battery, which may be a Lithium Thionyl Chloride battery or any other suitable type of battery. The power supply circuit comprises a current limiting circuit 106 and a Capacitor 107. The capacitor is charged with a charging current running from the battery through the current limiting circuit to the capacitor, whereby a voltage is built over the capacitor and energy is stored in the capacitor. Power is delivered to the devices powered by the power supply circuit from the capacitor in that a current is running from the capacitor to the supplied circuits. A part of the current running out of the power supply will be delivered from a current running out of the current limiting circuit and directly to the supplied circuits.

The current limiting circuit comprises two resistors R1, R2 and a switch S1. The switch S1 is controlled by the controller unit 104.When the switch is open, i.e. R2 is disconnected, the charging current is limited by R1 alone. When the switch is closed, i.e. R2 is connected, the charging current is limited by the parallel coupling of the two resistors R1, R2.

If initially no power is delivered by the power supply circuit a charging current will be running through the current limiting circuit to charge the capacitor. When the capacitor is charged the voltage over the capacitor will increase until it reaches (approaches asymptotically) a output voltage of the battery, where after the current will cease to run.

When power is delivered from the power supply the capacitor is discharged which causes a voltage drop on the capacitor and a charging current will start running again. If the current supplied by the power supply unit is larger than the current delivered by the current limiting circuit the voltage over the capacitor will drop and go towards zero. If the current supplied by the power supply equals the current delivered by the current limiting circuit an equilibrium will be reached with a steady voltage or average voltage over the capacitor.

During a normal operation mode of the power supply circuit the switch S1 is open, whereby a low average current can be drawn from the power supply and the resulting power delivered by the power supply will be low. The current peaks drawn from the battery will also be kept low. The voltage drop on the capacitor may be high without a high current is drawn from the battery.

During a boost operation mode of the power supply circuit the switch S1 is closed, whereby a higher average current can be drawn from the power supply than in the normal operation mode. This means that the resulting power delivered by the power supply circuit is increased and current peaks drawn from the battery is increased as well. The voltage drop on the capacitor may be reduced due to a higher charging current.

During the boost mode operation the current is limited by a lower resistance than in the normal operation mode, which means that the current peaks drawn from the battery are increased which is undesired if happening frequently but acceptable if happening infrequently.

During normal activity the utility meter measures the consumption of a delivered utility and transmits consumption related data via the radio circuit to a reading system. Such normal activity requires a low average current from the power supply circuit. In special situations the utility meter performs more advanced functionality including longer radio communication sessions. Such communication sessions may include reception and transmission of several radio bursts or splitting data up in multiple frames or data bursts to be received and transmitted. An example of such a two way communication protocol suitable for longer communication sessions is the wireless M-Bus protocol as described in EN13757-4:2013 and EN 13757-3:2018 and 13757-7:2018 but other suitable communication protocols may be used as well. The more advanced longer communication sessions will require a higher average current to be delivered from the power supply circuit.

The switch S1 is controlled by the controller unit to switch the power supply circuit between the normal mode and the boost mode. Boost mode may be selected due to advanced functionality, requiring an increased average current, activated by the utility meter itself. External events not controlled by the controller unit may as well require the power supply circuit to be in boost mode. Such external event may be that an advanced communication session is initiated by the reading system. If the controller unit detects that an advanced communication session has started or is to be initiated, it will control the switch S1 to make the power supply enter the boost mode operation which allows for a higher average current delivered from the power supply circuit.

The controller unit may detect a longer session simply by analysing a received radio signal to determine the duration of the radio signal or the summated duration of several radio signal bursts. If the duration exceeds a predefined limit the controller unit may change the mode of the power supply to boost operation mode.

Alternatively the controller unit analyses a received radio signal to determine a communication sequence type and if the communication sequence type includes multiple radio communication bursts the controller unit may change the mode of the power supply to the boost mode. The type of communication sequence may be indicated in a header of the received radio signal. Usually communication protocol describes headers wherein the type of communication e.g. one way or two way or broadcast etc. is specified, Often the number of subsequent radio bursts or packet fragments can be determined from one or more header structures of the data packets or control packets.

The controller unit controls the mode of the power supply circuit to be in normal mode or boost mode according to information obtained by analysing the received radio signals. The controller unit may also use historical data or configuration data as basis for controlling the mode of the power supply unit.

The radio circuit may be implemented using a transceiver chip including a transmitter and a receiver or alternatively separate transmitters and receivers may be used. Often the transceiver is integrated with a microcontroller as a System on Chip (SoC) solution. In this way the radio circuit or at least parts of the radio circuit may be integrated with the controller unit. The radio circuit may include a Power Amplifier (PA) and an external Low Noise Amplifier (LNA). These elements may influence the current consumption of the radio circuit significantly. An active receiver may typically draw a current in the range of 4-50 mA from the power supply whereas a transmitter may typically draw a current in the range of 10-1000 mA for a output power in the range from 0-33 dBm. Besides the current used by the radio circuit during reception and transmission the controller unit may further use energy for receiving, demodulating and analysing the received radio signal.

When a current is drawn from the power supply circuit the capacitor will be discharged causing a voltage drop over the capacitor. The controller unit may additionally measure the capacitor voltage and control the power supply circuit to switch to boost mode if an acceptable voltage drop on the capacitor is exceeded.

The radio circuit may include multiple elements other than those mentioned in this description. Elements such as analogue filter, SAW filters, Analog to digital converters, digital signal processors, FPGA's etc. are general known by the skilled person. The radio circuit may be a conventional radio circuit or a SW defined radio (SDR). The power supply circuit may be arranged to supply all or only some of the components or sub circuits of the radio circuit.

The invention can be implemented by means of hardware, software, firmware or any combination of these. The invention or some of the features thereof can also be implemented as software running on one or more data processors and/or digital signal processors.

The individual elements of an embodiment of the invention may be physically, functionally and logically implemented in any suitable way such as in a single unit, in a plurality of units or as part of separate functional units. The invention may be implemented in a single unit, or be both physically and functionally distributed between different units and processors.

Although the present invention has been described in connection with the specified embodiments, it should not be construed as being in any way limited to the presented examples. The scope of the present invention is to be interpreted in the light of the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A utility meter (100) for measuring an amount of a utility delivered to a consumption site and for transmitting consumption related data to a meter reading system, the utility meter comprising:
- a radio transmitter (101) and a radio receiver (101);
- a power supply circuit (102) arranged to power the radio receiver (101);
- a battery (103) arranged to supply energy to the power supply circuit (102); and
- a controller unit (104) configured to analyse a radio signal received by the radio receiver,
wherein the power supply circuit comprises:
-a capacitor (107) arranged to be charged by the battery (103) and to supply energy to the radio transmitter and / or radio receiver (101); and
-a current limiting circuit (106) arranged to limit a charging current running from the battery to the power supply circuit (102),
**characterized in that**,
the current limiting circuit (106) is controlled by the controller unit to have a normal mode and a boost mode where the charging current is limited more in normal mode than in boost mode and **in that** the controller unit (104) is configured to analyse a radio signal received by the radio receiver (101) to determine a parameter of the received radio signal and to control the current limiting circuit to switch to the boost mode according to the determined parameter.

2. The utility meter according to claim 1, wherein the controller unit (104) is configured to determine a duration of the received radio signal and control the current limiting circuit (106) according to the determined duration of the received radio signal.

3. The utility meter according to any of the preceding claims, wherein the controller unit (104) is configured to analyse the received radio signal to determine a communication sequence type and control the current limiting circuit (106) according to the determined communication sequence type.

4. The utility meter according to any of the preceding claims, wherein the controller unit (104) is configured to analyse the received radio signal to determine an expected duration of the received signal and control the current limiting circuit (106) according to the determined expected duration.

5. The utility meter according to any of the preceding claims, wherein the controller unit (104) is configured to analyse the received radio signal to determine if the received radio signal is a start of a communication session including multiple radio signal bursts to be received and control the current limiting circuit (106) according to a number of radio signal bursts to be received or transmitted.

6. The utility meter according to any of the preceding claims, wherein the current limiting circuit comprises a variable resistor.

7. The utility meter according to any of the preceding claims, wherein the current limiting circuit (106) comprises at least two resistors (R1, R2) and at least one switch (S1) arranged to create a variable serial resistance through which the charging current is running, where the switch is controlled by the controller unit (104).

8. The utility meter according to any of the preceding claims, wherein the controller unit is configured to determine the parameter of the received radio signal during reception or processing of the received radio signal and to switch between normal mode and boost mode during reception or processing of the received radio signal.
